(19)

Europäisches
Patentamt
European
Patent Office
Office européen
des brevets

(11) **EP 3 157 024 A1**

(12) **EUROPEAN PATENT APPLICATION**
published in accordance with Art. 153(4) EPC

(43) Date of publication:
**19.04.2017 Bulletin 2017/16**

(21) Application number: **15809986.1**

(22) Date of filing: **12.06.2015**

(51) Int Cl.:
*H01G 9/12* (2006.01)      *H01G 11/14* (2013.01)
*H01M 2/12* (2006.01)

(86) International application number:
**PCT/JP2015/067001**

(87) International publication number:
**WO 2015/194471 (23.12.2015 Gazette 2015/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **16.06.2014   JP 2014123501**

(71) Applicant: **Nitto Denko Corporation
Ibaraki-shi, Osaka 567-8680 (JP)**

(72) Inventors:
• **FUKUOKA, Takahiro
Ibaraki-shi
Osaka 567-8680 (JP)**
• **KIRA, Yoshiko
Ibaraki-shi
Osaka 567-8680 (JP)**

• **ISHII, Kyoko
Ibaraki-shi
Osaka 567-8680 (JP)**
• **HATA, Kenta
Ibaraki-shi
Osaka 567-8680 (JP)**
• **YUKAWA, Hiroshi
Nagoya-shi
Aichi 464-8601 (JP)**
• **NANBU, Tomonori
Suzuka-shi
Mie 510-0294 (JP)**

(74) Representative: **Grünecker Patent- und
Rechtsanwälte
PartG mbB
Leopoldstraße 4
80802 München (DE)**

(54) **HYDROGEN RELEASE FILM**

(57)   The present invention provides a hydrogen-releasing film and a hydrogen-releasing laminated film that have high reliability as a safety valve since defects such as cracks do not occur before the internal pressure of an electrochemical element reaches a predetermined pressure. The hydrogen-releasing film contains an alloy having Pd as an essential metal, and the size of the crystal grains in the alloy is 0.028 $\mu$m or more.

FIG.1

## Description

TECHNICAL FIELD

The present invention relates to a hydrogen-releasing film that is provided on an electrochemical element or the like such as a battery, a condenser, a capacitor, a sensor, or the like. Specifically, the present invention relates to a hydrogen-releasing film having a function of releasing the generated hydrogen to the outside in a usage environment of about 150°C or less, in an electrochemical element or the like whose internal pressure is increased due to the hydrogen gas generated during use.

BACKGROUND ART

In recent years, aluminum electrolytic capacitors have been used in an application for inverters such as the wind power generation and solar power generation, and large-scale power sources such as batteries. In the aluminum electrolytic capacitors, hydrogen gas may be generated therein by a reverse voltage, overvoltage, and overcurrent, and there is a risk of rupture of an outer case by an increase in the internal pressure due to the generation of a large amount of hydrogen gas.

Therefore, ordinary aluminum electrolytic capacitors are provided with a safety valve having a special film. In addition to a function of releasing hydrogen gas in the inside of the capacitor to the outside, the safety valve has another function of preventing the rupture of the capacitor itself by self-destruction enabling to decrease the internal pressure of the capacitor when it is abruptly increased. As the special film that is a component of such a safety valve, for example, the following has been proposed.

Patent Document 1 has proposed a pressure regulator film equipped with a foil strip composed of a Pd-Ag alloy wherein 20 wt% (19.8 mol%) of Ag is incorporated into palladium.

On the other hand, lithium-ion batteries are widely used in cellular phones, notebook computers, automobiles, or the like. Also in recent years, an interest in security for the lithium-ion batteries has grown in addition to higher capacity and improved cycle characteristics. In particular, gas generation in the cells of the lithium-ion batteries is known, and expansion and rupture of the battery pack accompanied with an internal pressure rise are concerned.

Patent Document 2 discloses use of an amorphous alloy (for example, 36Zr-64Ni alloy) composed of zirconium (Zr) and nickel (Ni) as a hydrogen permselective alloy film that selectively permeates hydrogen gas generated in the battery.

Such an alloy film is required to cause no self-destruction until the internal pressure of an electrochemical element reaches a pressure equal to or greater than a predetermined value. However, the conventional alloy film has a problem such that the film has low reliability as a safety valve because cracks may occur in the film or the film may be broken to pieces before the internal pressure of the electrochemical element reaches a predetermined pressure.

Prior Art Document

Patent Documents

Patent Document 1: Japanese patent No. 4280014
Patent Document 2: JP-A-2003-297325

SUMMARY OF THE INVENTION

Problems to be Solved by the Invention

The present invention has been made in view of the above problems, and an object thereof is to provide a hydrogen-releasing film and a hydrogen-releasing laminated film that have high reliability as a safety valve since defects such as cracks do not occur before the internal pressure of an electrochemical element reaches a predetermined pressure. In addition, it is another object of the present invention to provide a safety valve for an electrochemical element, wherein the valve is provided with the hydrogen-releasing film or the hydrogen-releasing laminated film, and to provide an electrochemical element having the safety valve.

MEANS FOR SOLVING THE PROBLEMS

The invention is related to a hydrogen-releasing film containing an alloy having Pd as an essential metal, wherein the size of the crystal grains in the alloy is 0.028 μm or more.

The hydrogen-releasing film containing an alloy having Pd as an essential metal is composed of polycrystals. Further, when hydrogen is allowed to permeate through the hydrogen-releasing film, the hydrogen threads between the gaps of the atoms constituting the hydrogen-releasing film. That is, hydrogen is once occluded in the hydrogen-releasing film. In addition, the hydrogen in such movement is replaced with the atoms in the hydrogen-releasing film and remains in the hydrogen-releasing film. That is, the hydrogen is accumulated in the hydrogen-releasing film, and thus the volume of the hydrogen-releasing film is changed to generate a stress due to the volume change. Since this stress is concentrated on the interface between the crystal grains, which is also said to be structural defects in the film (crystal grain boundaries), distortion occurs at the interface between the crystal grains. As a result, defects such as cracks in the hydrogen-releasing film are considered to occur.

As a result of studies based on the finding, the present inventors found that in the case of a hydrogen-releasing film containing an alloy having Pd as an essential metal, if the size of the crystal grains in the alloy is 0.028 μm or more, defects such as cracks hardly occur in the hydrogen-releasing film because stress concentration on the interface between the crystal grains is suppressed.

The alloy preferably contains a Group 11 element in an amount of 20 to 65 mol%. Further, the Group 11 element is preferably at least one kind selected from the group consisting of gold, silver, and copper.

A hydrogen-releasing film containing a Pd-Group 11 element alloy has a function to dissociate a hydrogen molecule into a hydrogen atom on the film surface; solve the hydrogen atom in the film; diffuse the hydrogen atom-solution to the low pressure side from the high pressure side; convert the hydrogen atom into the hydrogen molecule again on the film surface of the low pressure side; and release the hydrogen gas. If the content of the Group 11 element is less than 20 mol%, there is a tendency that the strength of the alloy becomes insufficient and the function of the alloy is hardly developed. If the content of the Group 11 element exceeds 65 mol%, the hydrogen permeation rate tends to decrease.

The hydrogen permeation coefficient of the hydrogen-releasing film at 50°C is preferably $1.0 \times 10^{-13}$ to $2.0 \times 10^{-9}$ (mol·m$^{-1}$·sec$^{-1}$·Pa$^{-1/2}$), and the film thickness t and the film area s preferably satisfy the following expression 1.

$$\text{<Expression 1>} \quad t/s < 32.9 \text{ m}^{-1}$$

The hydrogen-releasing film provided to an electrochemical element is determined to have a hydrogen permeation amount of 10 ml/day or more ($4.03 \times 10^{-4}$ mol/day or more: calculated according to SATP (temperature 25°C; volume of 1 mol ideal gas at an atmospheric pressure of 1 bar: 24.8 L)) at square root of 76.81 Pa$^{1/2}$ (0.059 bar) of the pressure. The hydrogen-releasing film having the Group 11 element content of 20 to 65 mol% in the Pd-Group 11 element alloy of the present invention has a hydrogen permeation coefficient of $1.0 \times 10^{-13}$ to $2.0 \times 10^{-9}$ (mol·m$^{-1}$· sec$^{-1}$·Pa$^{-1/2}$) at 50°C. Here, the hydrogen permeability coefficient is determined by the following expression 2.

$$\text{<Expression 2>}$$

$$\text{Hydrogen permeation coefficient} = \frac{(\text{Hydrogen moles} \times \text{film thickness t})}{(\text{film area s} \times \text{time} \times \text{Square root of pressure})}$$

In the case where the hydrogen permeation amount is 10 ml/day ($4.03 \times 10^{-4}$ mol/day) and the hydrogen permeation coefficient is $2.0 \times 10^{-9}$ (mol·m$^{-1}$·sec$^{-1}$·Pa$^{-1/2}$), each numerical value is assigned to the expression 2 as follows.

$$2.0 \times 10^{-9} = \frac{(4.03 \times 10^{-4} \times \text{film thickness t})}{(\text{film area s} \times 86400 \times 76.81)}$$

$$2.0 \times 10^{-9} = 6.08 \times 10^{-11} \times \text{film thickness t/film area s}$$

$$\text{Film thickness t/Film area s} = 32.9\ m^{-1}$$

Therefore, in the case of using a hydrogen permeation film having a hydrogen permeation coefficient of $1.0 \times 10^{-13}$ to $2.0 \times 10^{-9}$ (mol·m$^{-1}$·sec$^{-1}$·Pa$^{-1/2}$) at 50°C, the condition in which the hydrogen permeation amount becomes 10 ml/day or more ($4.03 \times 10^{-4}$ mol/day or more) satisfies the following expression: film thickness t/film area s < 32.9 m$^{-1}$.

The hydrogen-releasing laminated film of the present invention has a support on one side or both sides of the hydrogen-releasing film. The support is provided in order to prevent the hydrogen-releasing film from falling into the electrochemical element when the hydrogen-releasing film is detached from the safety valve. In addition, the hydrogen-releasing film is required to have a self-destructive function as a safety valve when the internal pressure of the electrochemical element becomes equal to or greater than a predetermined value. If the hydrogen-releasing film is a thin film, it has a risk of self-destruction before the internal pressure of the electrochemical element reaches a predetermined value because of the low mechanical strength of the hydrogen-releasing film and results in failure to fulfill the function as a safety valve. Therefore, when the hydrogen-releasing film is a thin film, it is preferable to laminate a support on one side or both sides of the hydrogen-releasing film in order to improve the mechanical strength.

The support is preferably a porous body having an average pore diameter of 100 μm or less. If the average pore diameter is more than 100 μm, the surface smoothness of the porous body decreases, because of which in the production of the hydrogen-releasing film by the sputtering method or the like, it becomes difficult to form a hydrogen-releasing film having a uniform film thickness on the porous body, or pinholes or cracks tend to easily occur in the hydrogen-releasing film.

The support is preferably formed from at least one polymer selected from the group consisting of polytetrafluoroethylene, polysulfone, polyimide, polyamide-imide, and aramid, in view of chemical and thermal stability.

Also, the present invention relates to a safety valve for an electrochemical element, which is provided with the hydrogen-releasing film or the hydrogen-releasing laminated film, and relates to an electrochemical element having the safety valve. The electrochemical element includes, for example, an aluminum electrolytic capacitor and a lithium ion battery.

EFFECT OF THE INVENTION

The hydrogen-releasing film and the hydrogen-releasing laminated film according to the present invention are characterized in that they have high reliability as a safety valve since defects such as cracks do not occur before the internal pressure of an electrochemical element reaches a predetermined pressure. In addition, the hydrogen-releasing film and the hydrogen-releasing laminated film of the present invention not only can rapidly release only the hydrogen gas generated in the inside of the electrochemical element to the outside, but also can prevent impurities from the outside from penetrating the inside of the electrochemical element. Moreover, a safety valve provided with the hydrogen-releasing film and the hydrogen-releasing laminated film of the present invention can reduce the internal pressure by self-destruction if the internal pressure of the electrochemical element has rapidly increased, so that the rupture of the electrochemical element itself can be prevented. These effects enable the performance of the electrochemical element to be maintained for a long time, making it possible to prolong the life of the electrochemical element.

BRIEF DESCRIPTION OF THE DRAWINGS

Fig. 1 is a schematic sectional view showing the structure of the hydrogen-releasing laminated film of the present invention.
Fig. 2 is a schematic sectional view showing the another structure of the hydrogen-releasing laminated film of the present invention.

MODE FOR CARRYING OUT THE INVENTION

Hereinafter, embodiments of the present invention will be described.

As the raw material of the hydrogen-releasing film of the present invention, an alloy having Pd as an essential metal is used. There is no particular limitation on other metals forming the alloy. However, it is preferable to use a Group 11 element in view of easily adjusting the crystal grain size of the alloy to 0.028 μm or more, more preferable to use at least one kind selected from the group consisting of gold, silver, and copper, and even more preferable to use silver or copper. The alloy contains a Group 11 element preferably in an amount of 20 to 65 mol%, more preferably 30 to 65 mol%, even more preferably 30 to 60 mol%. By forming a hydrogen-releasing film with use of a Pd-Ag alloy having an Ag content of 20 mol% or more, a Pd-Cu alloy having a Cu content of 30 mol% or more, or a Pd-Au alloy having an Au content of 20 mol% or more, such a hydrogen-releasing film becomes less susceptible to embrittlement even at a low temperature range of about 50 to 60°C or less. Further, the alloy may contain a Group IB metal and/or a Group IIIA metal as long as the effect of the present invention is not impaired.

The crystal grain size of the alloy is 0.028 $\mu$m or more, preferably 0.04 $\mu$m or more, more preferably 0.1 $\mu$m or more, even more preferably 0.4 $\mu$m or more. The larger the grain size is, the more hardly the defects such as cracks occur. Thus, there is no particular limitation on the upper limit value of the crystal grain size, but the crystal grain size is preferably 1000 $\mu$m or less, more preferably 600 $\mu$m or less, from the viewpoint that it is necessary to reduce the internal pressure by the self-destruction when the internal pressure of the electrochemical element is rapidly increased.

The hydrogen-releasing film of the present invention can be produced by, for example, a rolling method, a sputtering method, a vacuum deposition method, an ion plating method, and a plating method, but when producing a thick hydrogen-releasing film, it is preferable to use the rolling method and when producing a thin hydrogen-releasing film, it is preferable to use the sputtering method.

The crystal grain size can be adjusted to, for example, the desired size by adjusting the temperature in producing the hydrogen-releasing film. The temperature at which a hydrogen-releasing film having a crystal grain size of 0.028 $\mu$m or more is produced is usually a temperature of from 50°C to the melting temperature of the alloy, preferably from 50°C to 500°C, more preferably from 100°C to 400°C. By rolling at the above-mentioned temperature in the case of a rolling method, or by heating the substrate for forming a sputtered film to the above-mentioned temperature in the case of the sputtering method, a hydrogen-releasing film having a desired crystal grain size can be produced.

Even when producing a hydrogen-releasing film outside the temperature range, it is possible to adjust the crystal grain size by heating the hydrogen-releasing film again and then cooling the film. Further, when heating the hydrogen-releasing film and then cooling the film to an ambient temperature (usually about room temperature), it is possible to increase the crystal grain size by slow cooling instead of quenching. In addition, by slow cooling, the film surface of the hydrogen-releasing film becomes smooth because the crystal growth rate of the whole film is made uniform. As a result, the stress concentration to the interface between the crystal grains is suppressed, and thus cracks are further less likely to occur in the hydrogen-releasing film.

Further, by increasing the pressure of the press or rolling rolls when producing a hydrogen-releasing film, pressing the produced hydrogen-releasing film at a high pressure, or passing the hydrogen-releasing film through high pressure rolling rolls, it is possible to adjust the crystal grain size. Thus, the surface of the hydrogen-releasing film is smoothened by application of a higher pressure. As a result, the stress concentration to the interface between the crystal grains is suppressed, and thus cracks are further less likely to occur in the hydrogen-releasing film.

The rolling method may be a hot rolling method or a cold rolling method. The rolling method is a method comprising rotating a pair or pairs of rolls (rollers) and processing a raw material, Pd alloy into a film by passing it between the rolls under pressure.

The thickness of the hydrogen-releasing film obtained by the rolling method is preferably 5 to 50 $\mu$m, more preferably 10 to 30 $\mu$m. If the thickness of the film is less than 5 $\mu$m, pinholes or cracks are likely to occur in the production of the film, and deformation of such a film easily occurs after absorbing hydrogen. On the other hand, when the thickness of the film is more than 50 $\mu$m, such a film is not desirable because its hydrogen-releasing performance is reduced due to a long time required for the hydrogen permeation and because the film is inferior in terms of cost.

The sputtering method is not particularly limited, and can be carried out by using a sputtering apparatus such as a parallel flat plate type sputtering apparatus, a sheet type sputtering apparatus, a passing type sputtering apparatus, a DC sputtering apparatus, and an RF sputtering apparatus. For example, after having attached a substrate to a sputtering apparatus in which a Pd-Ag alloy target is placed, the sputtering apparatus is evacuated, adjusted to a predetermined pressure value with an Ar gas, and a predetermined sputtering current is charged to the Pd-Ag alloy target, thereby to form a Pd-Ag alloy film on the substrate. Then, the Pd-Ag alloy film is peeled off from the substrate to obtain a hydrogen-releasing film. It should be noted that it is possible to use, as the target, a single or multiple targets according to the hydrogen-releasing film to be produced.

As the substrate, it includes, for example, a glass plate, a ceramic plate, a silicon wafer, and a metal plate such as aluminum and stainless steel.

The thickness of the hydrogen-releasing film obtained by the sputtering method is preferably 0.01 to 5 $\mu$m, more preferably 0.05 to 2 $\mu$m. If the thickness of the film is less than 0.01 $\mu$m, not only may pinholes be formed, but also it is difficult to obtain a required mechanical strength. Also, when the film is peeled off from the substrate, it is likely to be damaged and its handling after the peeling becomes difficult. On the other hand, when the thickness of the film is more than 5 $\mu$m, it takes time to produce the hydrogen-releasing film and such a film is inferior in regards to cost, which is not desirable.

The film area of the hydrogen-releasing film can be appropriately adjusted in consideration of the hydrogen permeation amount and the film thickness, but when the hydrogen-releasing film is used as a component of a safety valve, the film area is about 0.01 to 100 mm$^2$. It should be noted that the film area in the present invention is an area of actually releasing hydrogen in the hydrogen-releasing film and does not include a portion coated with a ring-shaped adhesive which will be described later.

The hydrogen-releasing laminated film may be formed by providing a support on one side or both sides of the hydrogen-releasing film. In particular, since the hydrogen-releasing film obtained by the sputtering method has a thin film thickness, it is preferable to laminate a support on one side or both sides of the hydrogen-releasing film in order to improve the mechanical strength.

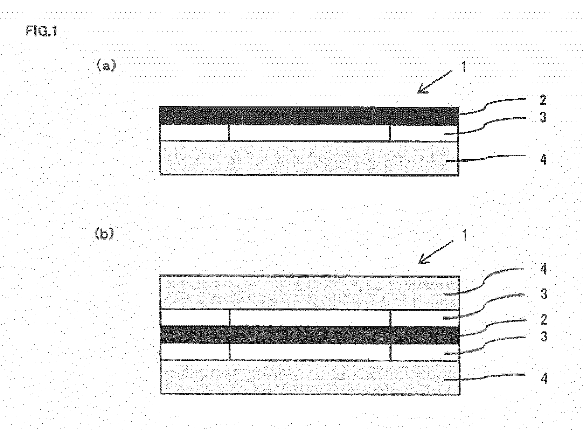

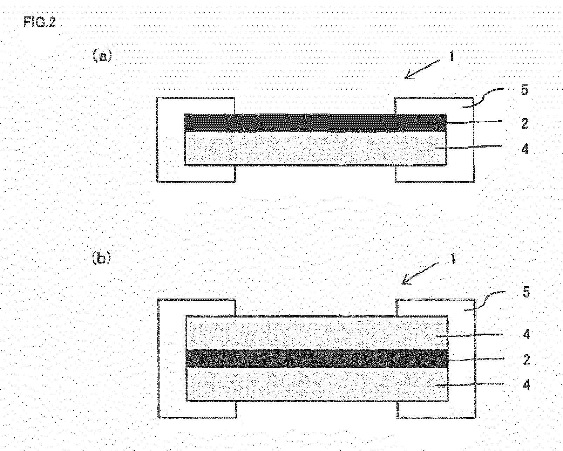

Fig. 1 and Fig. 2 are each a schematic sectional view showing the structure of a hydrogen-releasing laminated film 1 of the present invention. As shown in Fig. 1 (a) or 1(b), a support 4 may be laminated on one side or both sides of a hydrogen-releasing film 2 using a ring-shaped adhesive 3, and as shown in Fig. 2 (a) or 2(b), the support 4 may be laminated on one side or both sides of the hydrogen-releasing film 2 using a jig 5.

The support 4 is hydrogen permeable and is not particularly limited as long as it can support the hydrogen-releasing film 2. The support may be a non-porous body or may be a porous body. Also, the support 4 may be a woven fabric or may be a non-woven fabric. As a material for forming the support 4, it includes, for example, polyolefin such as polyethylene and polypropylene, polyester such as polyethylene terephthalate and polyethylene naphthalate, polyarylethersulfone such as polysulfone and polyethersulfone, fluororesin such as polytetrafluoroethylene and polyvinylidene fluoride, epoxy resin, polyamide, polyimide, polyamide-imide, aramid and the like. Of these, at least one kind selected from the group consisting of polytetrafluoroethylene, polysulfone, polyimide, polyamide-imide, and aramid, which are chemically and thermally stable, is preferably used.

The thickness of the support 4 is not particularly limited, but is usually about 5 to 1000 $\mu$m, preferably 10 to 300 $\mu$m.

When producing the hydrogen-releasing film 2 by the sputtering method, such film can be directly formed on the support 4 which is used as a substrate and the hydrogen-releasing laminated film 2 can be produced without using the adhesive 3 or jig 5. Thus, this method is preferable from the viewpoint of physical properties and production efficiency of the hydrogen-releasing laminated film 1. In that case, it is preferable to use, as the support 4, a porous body having an average pore diameter of 100 $\mu$m or less, more preferable to use a porous body having an average pore diameter of 5 $\mu$m or less, and particularly preferable to use an ultrafiltration membrane (UF membrane).

The shape of the hydrogen-releasing film and the hydrogen-releasing laminated film of the present invention may be substantially circular or polygonal such as triangle, square, and pentagon. Any shape can be taken depending on the application to be described later.

The hydrogen-releasing film and the hydrogen-releasing laminated film of the present invention are particularly useful as a component of a safety valve for an aluminum electrolytic capacitor or a lithium ion battery. Furthermore, the hydrogen-releasing film and the hydrogen-releasing laminated film of the present invention may be provided on an electrochemical element as a hydrogen-releasing valve aside from the safety valve.

Examples

Description will be given of the invention with examples, while the invention is not limited to description in the examples.

Example 1

[Preparation of Hydrogen-Releasing Film by Rolling Method (Content of Ag: 20 mol%)]

The raw materials Pd and Ag were each weighed so that the content of Ag in an ingot became 20 mol%, charged into an arc melting furnace equipped with a water-cooled copper crucible and subjected to arc melting in an Ar gas atmosphere under atmospheric pressure. The obtained button ingot was cold-rolled to a thickness of 5 mm using a two-stage rolling mill having a diameter of 100 mm to obtain a rolled sheet material. Then the rolled sheet material was placed in a glass tube and the both ends of the glass tube were sealed. After reducing the inside pressure of the glass tube to 5 $\times$ 10$^{-4}$ Pa at room temperature, the temperature was then raised to 700°C and the glass tube was allowed to stand for 24 hours, followed by cooling to room temperature. By this heat treatment, the segregation of Pd and Ag in the alloy was removed. Then, the sheet material was cold-rolled to 100 $\mu$m using a two-stage rolling mill having a roll diameter of 100 mm and further cold-rolled to 25 $\mu$m using a two-stage rolling mill having a roll diameter of 20 mm. Then the rolled sheet material was placed in a glass tube and the both ends of the glass tube were sealed. The inside pressure of the glass tube was reduced to 5 $\times$ 10$^{-4}$ Pa at room temperature, the temperature was then raised to 700°C, and the glass tube was allowed to stand for 1 hour, followed by cooling to room temperature. By this heat treatment, the internal strain in the Pd-Ag alloy caused by rolling was removed, to prepare a hydrogen-releasing film containing Pd-Ag and having a thickness t of 25 $\mu$m and an Ag content of 20 mol%.

Example 2

[Preparation of Hydrogen-Releasing Film by Rolling Method (Content of Ag: 22 mol%)]

A hydrogen-releasing film containing Pd-Ag and having a thickness t of 25 $\mu$m and an Ag content of 22 mol% was prepared in the same manner as in Example 1, except that the raw materials Pd and Ag were respectively used so that the content of Ag in an ingot became 22 mol%.

Example 3

[Preparation of Hydrogen-Releasing Film by Rolling Method (Content of Ag: 60 mol%)]

A hydrogen-releasing film containing Pd-Ag and having a thickness t of 25 $\mu$m and an Ag content of 60 mol% was prepared in the same manner as in Example 1, except that the raw materials Pd and Ag were respectively used so that the content of Ag in an ingot became 60 mol%.

Example 4

[Preparation of Hydrogen-Releasing Film by Rolling Method (Content of Ag: 19.8 mol%)]

A hydrogen-releasing film containing Pd-Ag and having a thickness t of 25 $\mu$m and an Ag content of 19.8 mol% was prepared in the same manner as in Example 1, except that the raw materials Pd and Ag were respectively used so that the content of Ag in an ingot became 19.8 mol%.

Example 5

[Preparation of Hydrogen-Releasing Laminated Film by Sputtering Method (Content of Ag: 20 mol%)]

A polysulfone porous sheet (pore diameter: 0.001 to 0.02 $\mu$m, manufactured by NITTO DENKO CORPORATION) as a support was attached to an RF magnetron sputtering apparatus (manufactured by Sanyu Electron Co., Ltd.) equipped with a Pd-Ag alloy target in which the content of Ag is 20 mol%. Then, after evacuation of air in the sputtering apparatus to $1 \times 10^{-5}$ Pa or less, a sputtering current of 4. 8 A was applied to the Pd-Ag alloy target under 300°C and an Ar gas pressure of 1.0 Pa to form a Pd-Ag alloy film with 400 nm thickness t (Ag content: 20 mol%) on a polysulfone porous sheet to prepare a hydrogen-releasing laminated film.

Example 6

[Preparation of Hydrogen-Releasing Laminated Film by Sputtering Method (Content of Ag: 19.8 mol%)]

A Pd-Ag alloy film (Ag content: 19.8 mol%) having a thickness t of 400 nm was formed in the same manner as in Example 5, except that a Pd-Ag alloy target having an Ag content of 19.8 mol% was used, whereby a hydrogen-releasing laminated film was prepared.

Example 7

[Preparation of Hydrogen-Releasing Laminated Film by Sputtering Method (Content of Cu: 53 mol%)]

A Pd-Cu alloy film (Cu content: 53 mol%) having a thickness t of 400 nm was formed in the same manner as in Example 5, except that a Pd-Cu alloy target having an Cu content of 53 mol% was used, whereby a hydrogen-releasing laminated film was prepared.

Example 8

[Preparation of Hydrogen-Releasing Laminated Film by Sputtering Method (Content of Au: 20 mol%)]

A Pd-Au alloy film (Au content: 20 mol%) having a thickness t of 400 nm was formed in the same manner as in Example 5, except that a Pd-Au alloy target having an Au content of 20 mol% was used, whereby a hydrogen-releasing laminated film was prepared.

Example 9

[Preparation of Hydrogen-Releasing Film by Rolling Method (Content of Au: 30 mol%)]

A hydrogen-releasing film containing Pd-Au and having a thickness t of 25 $\mu$m and an Au content of 30 mol% was prepared in the same manner as in Example 1, except that the raw materials Pd and Au were respectively used so that the content of Au in an ingot became 30 mol%.

Example 10

[Preparation of Hydrogen-Releasing Film by Rolling Method (Content of Au: 40 mol%)]

A hydrogen-releasing film containing Pd-Au and having a thickness t of 25 $\mu$m and an Au content of 40 mol% was prepared in the same manner as in Example 1, except that the raw materials Pd and Au were respectively used so that the content of Au in an ingot became 40 mol%.

Example 11

[Preparation of Hydrogen-Releasing Laminated Film by Sputtering Method (Content of Au: 30 mol%)]

A Pd-Au alloy film (Au content: 30 mol%) having a thickness t of 400 nm was formed in the same manner as in Example 5, except that a Pd-Au alloy target having an Au content of 30 mol% was used, whereby a hydrogen-releasing laminated film was prepared.

Example 12

[Preparation of Hydrogen-Releasing Laminated Film by Sputtering Method (Content of Au: 40 mol%)]

A Pd-Au alloy film (Au content: 40 mol%) having a thickness t of 400 nm was formed in the same manner as in Example 5, except that a Pd-Au alloy target having an Au content of 40 mol% was used, whereby a hydrogen-releasing laminated film was prepared.

Comparative Example 1

[Preparation of Hydrogen-Releasing Laminated Film by Sputtering Method (Content of Ag: 19.8 mol%)]

A Pd-Ag alloy film (Ag content: 19.8 mol%) having a thickness t of 400 nm was formed in the same manner as in Example 5, except that a Pd-Ag alloy target having an Ag content of 19.8 mol% was used and the temperature at the time of sputtering was 25°C, whereby a hydrogen-releasing laminated film was prepared.

Comparative Example 2

[Preparation of Hydrogen-Releasing Laminated Film by Sputtering Method (Content of Ag: 20 mol%)]

A Pd-Ag alloy film (Ag content: 20 mol%) having a thickness t of 400 nm was formed in the same manner as in Example 5, except that the temperature at the time of sputtering was 25°C, whereby a hydrogen-releasing laminated film was prepared.

[Measurement and Evaluation Methods]

(Measurement of Crystal Grain Size of Hydrogen-Releasing Film)

The surface of the produced hydrogen-releasing film was photographed using an optical microscope (ECLIPSE ME600, manufactured by Nikon Corporation) at a magnification of 50 times. Then, the photographed image was binarized using image analysis software (the United States National Institutes of Health [NIH], open source, "Image J"). In the binarization, the crystal grains were to be displayed in the bright part. Thereafter, the crystal grains were highlighted by correcting the brightness and contrast, and only the crystal grains were selected through setting of a threshold to obtain a binarized image. Then, the resulting binarized image was analyzed using image analysis software ("A-ZO KUN," manufactured by Asahi Kasei Engineering Corporation). Incidentally, the bright part in the binarized image was taken as crystal grains, and the crystal grains overlapping the outer edge sides of the rectangular analysis range (3 mm $\times$ 2 mm) were excluded from the analysis. In addition, in the binarized image, when there were voids in the inside of the crystal grains gathered together, processing of filling such voids was not performed. Further, in the binarized image, processing of separating the crystal grains in contact with each other was not performed. The equivalent circle diameter determined by the above operation was taken as the crystal grain diameter (crystal grain size).

(Measurement of Crystal Grain Size of Hydrogen-Releasing Laminated Film)

The surface of the produced hydrogen-releasing laminated film was photographed using a scanning electron microscope (S-3000N, manufactured by Hitachi High-Technologies Corporation) at a magnification of 100000 times. Then, the photographed image was binarized using image analysis software (the United States National Institutes of Health [NIH], open source, "Image J"). In the binarization, the crystal grains were to be displayed in the bright part. Thereafter, the crystal grains were highlighted by correcting the brightness and contrast, and only the crystal grains were selected through setting of a threshold to obtain a binarized image. Then, the resulting binarized image was analyzed using image analysis software ("A-ZO KUN," manufactured by Asahi Kasei Engineering Corporation). Incidentally, the bright part in the binarized image was taken as crystal grains, and the crystal grains overlapping the outer edge sides of the rectangular analysis range (1.5 $\mu$m $\times$ 1 $\mu$m) were excluded from the analysis. In addition, in the binarized image, when there were voids in the inside of the crystal grains gathered together, processing of filling such voids was not performed. Further, in the binarized image, processing of separating the crystal grains in contact with each other was not performed. The equivalent circle diameter determined by the above operation was taken as the crystal grain diameter (crystal grain size).

(Measurement of Hydrogen Permeation Coefficient)

The prepared hydrogen-releasing film or the prepared hydrogen-releasing laminated film was attached to a VCR connector manufactured by Swagelok Company, and an SUS tube was attached to one side of the connector. In this way, a sealed space (63.5 ml) was produced. After the pressure inside the tube was reduced by a vacuum pump, the pressure of the hydrogen gas was adjusted to 0.15 MPa, and a pressure change in an environment of 50°C was monitored. Since the number of moles of hydrogen transmitted through the hydrogen-releasing film can be known by the pressure change, a hydrogen permeation coefficient was calculated by substituting the number of moles of hydrogen into the expression 2 below. In addition, the effective film area s of the hydrogen-releasing film used for the measurement is $3.85 \times 10^{-5}$ m$^2$, and the effective film area s of the hydrogen-releasing laminated film is $7.07 \times 10^{-6}$ m$^2$.

$$< \text{Expression 2}> \text{Hydrogen permeation coefficient} = (\text{Number of moles of hydrogen} \times \text{Film thickness t})/(\text{Film area s} \times \text{time} \times \text{square root of pressure})$$

(Evaluation of Deterioration of Hydrogen-Releasing Film)

The produced hydrogen-releasing film or the produced hydrogen-releasing laminated film was attached and fixed to a hydrogen tank with a double-sided pressure-sensitive adhesive tape (No. 5615, manufactured by Nitto Denko Corporation). Thereafter, the hydrogen partial pressure in the hydrogen tank was adjusted to 0.05 MPa, and the film was allowed to stand in an environment of 50°C for 12 hours. Then, the state of the hydrogen-releasing film was observed, and evaluated based on the following criteria.

⊙: No change when observed with a microscope (magnification of 100 times)
○: There were a few cracks when observed with a microscope (magnification of 100 times)
×: Broken to pieces

(Evaluation of Hydrogen Embrittlement of Hydrogen-Releasing Film Prepared by Rolling Method)

The prepared hydrogen-releasing film was placed in a glass tube and the both ends of the glass tube were sealed. The inside pressure of the glass tube was reduced to a pressure of $5 \times 10^{-3}$ Pa at 50°C, and the temperature was then raised to 400°C. Then hydrogen gas was introduced into the glass tube and allowed to stand for one hour under an atmosphere of 105 kPa. Thereafter, the glass tube was cooled to room temperature and the inside of the glass tube was evacuated to a pressure of $5 \times 10^{-3}$ Pa (30 minutes). Then, hydrogen gas was introduced into the glass tube again and allowed to stand for one hour under an atmosphere of 105 kPa. After repeating the above operation three times, the hydrogen-releasing film was removed from the glass tube and the appearance of the hydrogen-releasing film was visually observed and evaluated by the following criteria.

○: No change in appearance such as distortion
×: Change in appearance such as distortion

(Evaluation of Hydrogen Embrittlement of Hydrogen- Releasing Laminated Film Prepared by Sputtering Method)

The prepared hydrogen-releasing laminated film was placed in a glass tube and the both ends of the glass tube were sealed. After the inside of the glass tube was reduced to a pressure of $5 \times 10^{-3}$ Pa at 50°C, hydrogen gas was introduced into the glass tube and the glass tube was allowed to stand for one hour under an atmosphere of 105 kPa. Thereafter, the hydrogen-releasing laminated film was removed from the glass tube and the surface of the film was observed by SEM, followed by evaluation using the following criteria.

○: There were no cracks
×: There were cracks

[Table 1]

| | Example 1 | Example 2 | Example 3 | Example 4 | Example 5 | Example 6 | Example 7 | Example 8 | Example 9 | Example 10 | Example 11 | Example 12 | Comparative Example 1 | Comparative Example 2 |
|---|---|---|---|---|---|---|---|---|---|---|---|---|---|---|
| Production method | Rolling method | Rolling method | Rolling method | Rolling method | Sputtering method | Sputtering method | Sputtering method | Sputtering method | Rolling method | Rolling method | Sputtering method | Sputtering method | Sputtering method | Sputtering method |
| Composition of alloy | PdAg (22%) | PdAg (20%) | PdAg (60%) | PdAg (19.8 %) | PdAg (20%) | PdAg (19.8% ) | PdCu (53%) | PdAu (20%) | PdAu (30%) | PdAu (40%) | PdAu (30%) | PdAu (40%) | PdAg (19.8%) | PdAg (20%) |
| Crystal grain size ($\mu$m) | 500 | 400 | 430 | 350 | 0.045 | 0.035 | 0.035 | 0.055 | 530 | 520 | 0.060 | 0.065 | 0.027 | 0.025 |
| Hydrogen permeation coefficient (mol·m$^{-1}$·sec$^{-1}$·Pa$^{-1/2}$) | $2 \times 10^{-10}$ | $2 \times 10^{-10}$ | $1 \times 10^{-13}$ | $3 \times 10^{-9}$ | $2 \times 10^{-9}$ | $2 \times 10^{-9}$ | $4 \times 10^{-9}$ | $7 \times 10^{-10}$ | $3.8 \times 10^{-10}$ | $8.9 \times 10^{-10}$ | $4 \times 10^{-10}$ | $7 \times 10^{-11}$ | $1 \times 10^{-9}$ | $1 \times 10^{-9}$ |
| t/s (m$^{-1}$) | 0.65 | 0.65 | 0.65 | 0.65 | 0.057 | 0.057 | 0.057 | 0.057 | 0.65 | 0.65 | 0.057 | 0.057 | 0.057 | 0.057 |
| Evaluation of deterioration of hydrogen-releasing film | ⊙ | ⊙ | ⊙ | ⊙ | ⊙ | ○ | ⊙ | ⊙ | ⊙ | ⊙ | ⊙ | ⊙ | × | × |
| Evaluation of hydrogen brittleness of hydrogen-releasing film | ○ | ○ | ○ | × | ○ | × | ○ | ○ | ○ | ○ | ○ | ○ | × | × |

INDUSTRIAL APPLICABILITY

The hydrogen-releasing film and the hydrogen-releasing laminated film according to the present invention are preferably used as a component of a safety valve provided on an electrochemical element such as a battery, a condenser, a capacitor, a sensor, and the like.

DESCRIPTION OF REFERENCE SIGNS

1: Hydrogen-releasing laminated film
2: Hydrogen-releasing film
3: Adhesive
4: Support
5: Jig

**Claims**

1. A hydrogen-releasing film containing an alloy having Pd as an essential metal, wherein the size of the crystal grains in the alloy is 0.028 $\mu$m or more.

2. The hydrogen-releasing film according to claim 1, wherein the alloy contains a Group 11 element in an amount of 20 to 65 mol%.

3. The hydrogen-releasing film according to claim 2, wherein the Group 11 element is at least one kind selected from the group consisting of gold, silver, and copper.

4. The hydrogen-releasing film according to claim 2 or 3, wherein the hydrogen permeation coefficient at 50°C is $1.0 \times 10^{-13}$ to $2.0 \times 10^{-9}$ (mol·m$^{-1}$·sec$^{-1}$·Pa$^{-1/2}$), and the film thickness t and the film area s satisfy the following expression 1.

$$<\text{Expression 1}>$$

$$t/s < 32.9 \ m^{-1}$$

5. A hydrogen-releasing laminated film, comprising a support on one surface or both surfaces of the hydrogen-releasing film according to any one of claims 1 to 4.

6. The hydrogen-releasing laminated film according to claim 5, wherein the support is a porous body having an average pore diameter of 100 $\mu$m or less.

7. The hydrogen-releasing laminated film according to claim 5 or 6, wherein a raw material of the support is at least one kind selected from the group consisting of polytetrafluoroethylene, polysulfone, polyimide, polyamide-imide, and aramid.

8. A safety valve for an electrochemical element, wherein the valve is provided with the hydrogen-releasing film according to any one of claims 1 to 4 or the hydrogen-releasing laminated film according to any one of claims 5 to 7.

9. An electrochemical element, wherein the element is provided with the safety valve according to claim 8.

10. The electrochemical element according to claim 9, wherein the electrochemical element is an aluminum electrolytic capacitor or a lithium ion battery.

FIG.1

(a)

(b)

FIG.2

(a)

(b)

<table>
<tr><td colspan="2" align="center">**INTERNATIONAL SEARCH REPORT**</td><td colspan="2">International application No.<br>PCT/JP2015/067001</td></tr>
</table>

**A. CLASSIFICATION OF SUBJECT MATTER**
*H01G9/12*(2006.01)i, *H01G11/14*(2013.01)i, *H01M2/12*(2006.01)i

According to International Patent Classification (IPC) or to both national classification and IPC

**B. FIELDS SEARCHED**

Minimum documentation searched (classification system followed by classification symbols)
H01G9/12, H01G11/14, H01M2/12

Documentation searched other than minimum documentation to the extent that such documents are included in the fields searched
Jitsuyo Shinan Koho            1922–1996    Jitsuyo Shinan Toroku Koho    1996–2015
Kokai Jitsuyo Shinan Koho    1971–2015    Toroku Jitsuyo Shinan Koho    1994–2015

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2006-055831 A  (Iwatani & Co., Ltd.),<br>02 March 2006 (02.03.2006),<br>claims; fig. 1<br>(Family: none) | 1-4<br>5-10 |
| Y | JP 2003-297325 A  (Sanyo Electric Co., Ltd.),<br>17 October 2003 (17.10.2003),<br>paragraphs [0001], [0018], [0019]<br>(Family: none) | 5-10 |
| Y | JP 2008-077945 A  (Dainippon Printing Co., Ltd.),<br>03 April 2008 (03.04.2008),<br>paragraphs [0012] to [0014]<br>(Family: none) | 7 |

☐ Further documents are listed in the continuation of Box C.        ☐ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    07 August 2015 (07.08.15) | Date of mailing of the international search report<br>    18 August 2015 (18.08.15) |
|---|---|
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4280014 B
- JP 2003297325 A